# EUROPÄISCHE PATENTANMELDUNG

(11) **EP 3 021 480 A1**
(43) Veröffentlichungstag der Anmeldung: **18.05.2016**
(21) Anmeldenummer: 15188527.4
(22) Anmeldetag: 06.10.2015
(51) Int. Cl.: H02P 27/08, H02P 29/024, H02P 6/14, H02P 29/032

(54) **ELEKTROMOTOR MIT EINEM LEISTUNGSMODUL**

(30) Priorität: 17.11.2014 DE 102014223361
(71) Anmelder: ROBERT BOSCH GMBH, 70442 Stuttgart (DE)
(72) Erfinder: Knagge, Dieter, 70839 Gerlingen (DE); Ruf, Christoph, 72800 Eningen (DE); Wiedemann, Sylvia, 71640 Ludwigsburg (DE); Jacob, Wolfgang, 72160 Horb (DE); Walter, Gerhard, 70839 Gerlingen (DE)

(57) **Zusammenfassung**

Die Erfindung betrifft einen elektronisch kommutierten Elektromotor mit einem Rotor und einem Stator umfassend wenigstens drei Statorspulen. Erfindungsgemäß weist der Elektromotor für jede Statorspule ein der Statorspule zugeordnetes Leistungsmodul auf, welches ausgangsseitig mit der Statorspule verbunden und ausgebildet ist, den Stator zum Erzeugen eines magnetischen Drehfeldes zu bestromen. Das Leistungsmodul weist eine Halbleiterschalter-Halbbrücke und eine Verarbeitungseinheit auf, welche ausgebildet ist, die Halbleiterschalter-Halbbrücke zum Erzeugen eines magnetischen Drehfeldes für einen der Statorspule entsprechenden Rotorumlaufabschnitt anzusteuern und dazu wenigstens in Abhängigkeit eines eingangsseitig empfangenen Auslösesignals ein Rotor-Steuersignal zu erzeugen, das ein rotorwinkelabhängiges Bestromungsmuster repräsentiert und dieses an die Halbleiterschalter-Halbbrücke zu senden. Bevorzugt weist das Leistungsmodul einen Eingang für ein Auslösesignal auf und ist ausgebildet, das Rotor-Steuersignal wenigstens in Abhängigkeit des Auslösesignals zu erzeugen.

## Beschreibung

### Stand der Technik

Die Erfindung betrifft einen elektronisch kommutierten Elektromotor. Der Elektromotor weist einen Stator und einen Rotor auf, wobei der Stator wenigstens drei Statorspulen aufweist. Der Rotor ist bevorzugt permanentmagnetisch ausgebildet. Der Elektromotor weist auch wenigstens ein mit dem Stator ausgangsseitig verbundenes Leistungsmodul auf, wobei das Leistungsmodul ausgebildet ist, den Stator zum Erzeugen eines magnetischen Drehfeldes zu bestromen.

### Offenbarung der Erfindung

Erfindungsgemäß weist der Elektromotor der eingangs genannten Art für jede Statorspule ein der Statorspule zugeordnetes Leistungsmodul auf, welches ausgangsseitig mit der Statorspule verbunden ist. Das Leistungsmodul weist eine Halbleiterschalter-Halbbrücke und eine Verarbeitungseinheit auf, welche ausgebildet ist, die Halbleiterschalter-Halbbrücke zum Erzeugen eines magnetischen Drehfeldes für einen der Statorspule entsprechenden Rotorumlaufabschnitt anzusteuern und dazu - bevorzugt wenigstens in Abhängigkeit eines eingangsseitig empfangenen Auslösesignals - ein Rotor-Steuersignal zu erzeugen. Das Rotor-Steuersignal repräsentiert bevorzugt ein - insbesondere von einem Rotorwinkel innerhalb des Rotorumlaufabschnitts abhängiges - Bestromungsmuster, insbesondere PWM-Muster (PWM = Puls-Weiten-Modulation), repräsentiert und dieses an die Halbleiterschalter-Halbbrücke zu senden. Bevorzugt weist das Leistungsmodul einen Eingang für ein Auslösesignal auf und ist ausgebildet, das Rotor-Steuersignal wenigstens in Abhängigkeit des Auslösesignals zu erzeugen.

Dadurch kann der Elektromotor, insbesondere eine Leistungsendstufe des Elektromotors, vorteilhaft modular aus den Leistungsmodulen gebildet sein. Weiter vorteilhaft können zueinander verschiedene Elektromotoren mit zueinander verschiedener Anzahl von Statorspulen für jede Statorspule das Leistungsmodul aufweisen. Das Leistungsmodul kann so für eine Vielzahl von Elektromotoren aufwandsgünstig bereitgestellt werden.

Die zeitliche Ansteuerung und Koordination des Rotorumlaufs kann vorteilhaft durch eine zentrale Verarbeitungseinheit erfolgen, welche bevorzugt dazu ausgebildet ist, ein Ansteuermuster, umfassend zeitlich aufeinanderfolgende Auslösesignale für die Leistungsmodule zu erzeugen und die Leistungsmodule gemäß dem Ansteuermuster anzusteuern. Die Leistungsmodule sind bevorzugt jeweils ausgebildet, das Rotor-Steuersignal, insbesondere PWM-Muster zum Erzeugen eines Bestromungsmusters für einen Rotorumlaufabschnitt zu erzeugen, welcher der mit dem Leistungsmodul verbundenen Statorspule entspricht und dieses an die Halbleiterschalter-Halbbrücke zu senden, welche die ausgangsseitig mit dem Leistungsmodul verbundene Statorspule mit dem dem Rotor-Steuersignal entsprechenden Bestromungsmuster bestromen kann.

Die Leistungsmodule können so - durch ein Ansteuersignal, umfassend ein Auslösesignal der zentralen Verarbeitungseinheit getriggert - das für den Rotorwinkelbereich und für ein gefordertes Drehmoment auf dem Rotorwinkelbereich erforderliche Bestromungsmuster erzeugen, so dass die Leistungsmodule des Elektromotors vorteilhaft eine Art Slave-Funktion aufweisen, wobei die Verarbeitungseinheit eine Master-Funktion aufweist, und dazu die jeweils ein Auslösesignal aufweisenden Ansteuersignale zum Triggern der Leistungsmodule erzeugt. Das Ansteuersignal weist bevorzugt zusätzlich zu dem Auslösesignal ein Drehmomentsignal auf, das ein zu erzeugendes Drehmoment auf dem Rotorwinkelabschnitt repräsentiert. Die zentrale Verarbeitungseinheit kann bevorzugt so auch eine Rotorumlauffrequenz des Rotors bestimmen.

Bevorzugt weist das Leistungsmodul einen Pulsweitenmodulator auf, welcher ausgebildet ist, das Rotor-Steuersignal, insbesondere PWM-Signal, oder Block-Kommutierungssignal zu erzeugen. Dadurch kann jedes Leistungsmodul vorteilhaft - bevorzugt unabhängig von den übrigen Leistungsmodulen - sein eigenes Rotor-Steuersignal erzeugen.

Anders als wie bei bisher eingesetzten Leistungsendstufen, welche im Wesentlichen Leistungskomponenten wie die Halbbrücken enthalten, kann das Leistungsmodul für den dem Leistungsmodul zugeordneten Rotorumlaufabschnitt das Bestromungsmuster erzeugen und vorteilhaft weitere Kontrollfunktionen ausführen und dazu einen Status des Leistungsmoduls, oder zusätzlich der Statorspule, repräsentierendes Statussignal erzeugen und dieses ausgangsseitig an die Verarbeitungseinheit ausgeben. Die Verarbeitungseinheit kann beispielsweise im Falle eines Defektes eines Leistungsmoduls ein Notlauf-Ansteuermuster, umfassend eine zeitliche Folge von Ansteuersignalen erzeugen und die verbleibenden, noch funktionierenden Leistungsendstufen zum Drehbewegen des Rotors mit dem Notlauf-Ansteuermuster ansteuern.

Die Verarbeitungseinheit des Leistungsmoduls weist bevorzugt eine Treibereinheit zum Ansteuern von Steueranschlüssen der Halbleiterschalter-Halbbrücke auf oder ist durch eine insbesondere intelligente Treibereinheit gebildet. Der Pulsweitenmodulator ist bevorzugt Bestandteil der Treibereinheit.

In einer bevorzugten Ausführungsform weist das Leistungsmodul eine Schnittstelle, insbesondere Daten-Schnittstelle auf, welche ausgebildet ist, ein Auslösesignal zum Erzeugen des Rotorsteuersignals zu empfangen. Weiter bevorzugt ist die Schnittstelle ausgebildet, ein von der Verarbeitungseinheit empfangenes Statussignal ausgangsseitig bereitzustellen.

Die Schnittstelle bildet bevorzugt den zuvor beschriebenen Eingang des Leistungsmoduls.

Die Verarbeitungseinheit ist bevorzugt ausgebildet, das Rotorsteuersignal in Abhängigkeit des Auslösesignals zu erzeugen und den Rotor so zum Drehbewegen anzusteuern. Das Leistungsmodul kann mittels der Schnittstelle, insbesondere einer Datenschnittstelle, beispielsweise einer seriellen Schnittstelle oder einem Datenbus, vorteilhaft modular als Teil des Elektromotors angesteuert werden.

Weiter vorteilhaft kann der Elektromotor zusätzlich zu den Leistungsmodulen und dem Stator eine zentrale Verarbeitungseinheit aufweisen, welche ausgebildet ist, die Leistungsmodule zum Erzeugen des Bestromungsmusters anzusteuern und dazu beispielsweise eine zeitliche Folge von Auslösesignalen zu erzeugen.

Der Elektromotor weist bevorzugt eine Schnittstelleneinheit auf, welche ausgebildet ist, mit den Schnittstellen der Leistungsmodule verbunden zu werden und mit den Schnittstellen der Leistungsmodule zu kommunizieren.

Die Schnittstelle, insbesondere Datenschnittstelle, ist bevorzugt durch einen Datenbus, insbesondere einen LIN-Datenbus, einen CAN-Datenbus (CAN = Controller-Area-Network), einen PSI5-Datenbus, einen PAS-Datenbus, einen SPI-Datenbus oder einen I2C-Datenbus gebildet.

Vorteilhaft kann der Elektromotor, insbesondere die Leistungsmodule des Elektromotors, so mittels eines in einem Fahrzeug vorhandenen Datenbus, beispielsweise eines CAN-Bus, angesteuert werden, sodass die zentrale Verarbeitungseinheit zum Steuern des Elektromotors durch eine zentrale Verarbeitungseinheit eines Fahrzeugs, auch Steuergerät genannt, gebildet sein kann.

In einer bevorzugten Ausführungsform weist das Leistungsmodul einen mit der Verarbeitungseinheit des Leistungsmoduls verbundenen Temperatursensor auf. Der Temperatursensor ist angeordnet und ausgebildet, eine Temperatur der Halbleiterschalter-Halbbrücke, insbesondere eines Halbleiterschalters der Halbleiterschalter-Halbbrücke, zu erfassen und ein die Temperatur repräsentierendes Temperatursignal zu erzeugen. Die Verarbeitungseinheit des Leistungsmoduls ist ausgebildet, das Temperatursignal zu empfangen und in Abhängigkeit ein Statussignal, insbesondere ein Fehlersignal, zu erzeugen und das Statussignal ausgangsseitig an die Schnittstelle auszugeben. Dadurch kann vorteilhaft ein Fehlersignal, welches beispielsweise eine Temperaturüberhöhung der Halbleiterschalter-Halbbrücke repräsentiert, über die Schnittstelle an eine zentrale Verarbeitungseinheit gesendet werden, welche in Abhängigkeit des Fehlersignals eine Notlauf-Ansteuerung der verbleibenden noch funktionsfähigen Leistungsendstufen durchführen kann.

In einer bevorzugten Ausführungsform weist das Leistungsmodul einen mit der Verarbeitungseinheit des Leistungsmoduls verbundenen Stromsensor auf, welcher ausgebildet ist, einen Ausgangsstrom der Halbbrücke und/oder einen durch die Halbbrücke fließenden Strom zu erfassen und ein den Strom repräsentierendes Stromsignal zu erzeugen. Die Verarbeitungseinheit ist ausgebildet, das Rotorsteuersignal in Abhängigkeit des Stromsignals zu erzeugen. Die Verarbeitungseinheit kann so vorteilhaft den durch die Halbbrücke fließenden Strom und/oder den Ausgangsstrom der Halbbrücke überwachen und in Abhängigkeit des Stromsignals das Rotor-Steuersignal erzeugen, oder ein einen Fehler repräsentierendes Statussignal, insbesondere Fehlersignal, erzeugen. Vorteilhaft kann mittels des Stromsensors ein Defekt der Statorspule oder ein Kurzschluss der Halbbrücke, insbesondere ein Shoot-Through-Zustand der Halbbrücke erfasst werden.

Der Stromsensor ist bevorzugt durch einen Magnetfeldsensor, insbesondere einen Hall-Sensor, einen AMR-Sensor (AMR ₌ Anisotrope-Magneto-Resistive) oder einen GMR-Sensor (Giant-Magneto-Resistive) gebildet. In einer anderen Ausführungsform ist der Stromsensor durch einen Widerstand, insbesondere Shunt-Widerstand, gebildet.

Durch den Magnetfeldsensor kann der durch die Halbbrücke fließende Strom, welcher ein Magnetfeld erzeugt, welches von dem Hall-Sensor erfasst werden kann, frei von ohmschen Widerstandsmessverlusten erfasst werden.

Die Halbleiterschalter der Halbleiterschalter-Halbbrücke sind jeweils bevorzugt als Transistor, als besonderer IGBT-Transistor (IGBT = Insulated-Gate-Bipolar-Transistor), oder Feldeffekttransistor ausgebildet. Bevorzugt sind ein Schaltstreckenanschluss des High-Side-Transistors und ein Schaltstreckenanschluss des Low-Side-Transistors mittels einer elektrischen Verbindungsleitung miteinander verbunden. Die elektrische Verbindungsleitung ist beispielsweise durch eine elektrisch leitfähige Schicht, insbesondere einen Lead-Frame, gebildet. Der Stromsensor kann so vorteilhaft in das Leistungsmodul, insbesondere ein Gehäuse des Leistungsmoduls, integriert sein. Das Leistungsmodul weist beispielsweise ein Gehäuse, insbesondere ein Mold-Gehäuse, auf, in welches die Halbleiterschalter-Halbbrücke und die Verarbeitungseinheit und die Schnittstelle eingebettet sind.

In einer bevorzugten Ausführungsform des Elektromotors ist die Verarbeitungseinheit ausgebildet, einen Fehler der Halbbrücke und/oder der Statorspule, insbesondere einen Kurzschluss der Halbleiterschalter-Halbbrücke und/oder eine Überspannung einer Versorgungsspannung der Halbleiterschalter-Halbbrücke zu erfassen und ein den Fehler repräsentierendes Fehlersignal zu erzeugen und an die Schnittstelle auszugeben. Die Verarbeitungseinheit ist bevorzugt ausgebildet, den Kurzschluss der Halbleiterschalter-Halbbrücke, insbesondere einen Kurzschluss wenigstens eines Halbleiterschalters der Halbleiterschalter-Halbbrücke, in Abhängigkeit des Stromsignals zu erfassen. Bevorzugt ist die Verarbeitungseinheit ausgebildet, die Überspannung der Versorgungsspannung der Halbleiterschalter-Halbbrücke in Abhängigkeit des Stromsignals zu erfassen.

Das Leistungsmodul, insbesondere die Verarbeitungseinheit, kann dazu einen Speicher aufweisen, in welchem wenigstens ein Datensatz vorrätig gehalten ist, welcher einen Betriebsstrom der Halbleiterschalter-Halbbrücke repräsentiert. Die Verarbeitungseinheit ist bevorzugt ausgebildet, wenigstens einen das Stromsignal repräsentierenden Strom-Datensatz zu erzeugen und den Strom-Datensatz mit den in dem Speicher vorrätig gehaltenen Betriebsstrom-Datensatz zu vergleichen und in Abhängigkeit eines Vergleichsergebnisses das Fehlersignal zu erzeugen.

In einer bevorzugten Ausführungsform weist das Leistungsmodul einen Spannungssensor, insbesondere einen Analog-Digital-Wandler, auf, wobei der Spannungssensor mit der Halbleiterschalter-Halbbrücke, insbesondere Versorgungsspannungsanschlüssen der Halbleiterschalter-Halbbrücke, verbunden ist und ausgebildet ist, eine Versorgungsspannung zum Betreiben der Halbleiterschalter-Halbbrücke zu erfassen und ein die Versorgungsspannung repräsentierendes Spannungssignal zu erzeugen und an die Verarbeitungseinheit zu senden. Die Verarbeitungseinheit ist bevorzugt mit dem Spannungssensor verbunden. So kann vorteilhaft die Betriebsspannung, welche an der Halbleiterschalter-Halbbrücke anliegt, exakt erfasst werden.

In einer bevorzugten Ausführungsform des Leistungsmoduls ist die Verarbeitungseinheit des Leistungsmoduls mit Steueranschlüssen, insbesondere Gate-Anschlüssen, der Halbleiterschalter verbunden. Die Verarbeitungseinheit ist ausgebildet, ein Steuersignal zum Durchsteuern oder Sperren der Halbleiterschalter zu erzeugen und dieses an die Halbleiterschalter zu senden. Vorteilhaft kann die Verarbeitungseinheit so die Funktion eines Gate-Treibers bilden.

In einer bevorzugten Ausführungsform weist wenigstens ein Leistungsmodul, weiter bevorzugt jedes der Leistungsmodule, einen Zwischenkreiskondensator auf, welcher mit Schaltanschlüssen der Halbleiterschalter-Halbbrücke des Leistungsmoduls verbunden ist. Vorteilhaft kann der Elektromotor so eine Vielzahl an Zwischenkreiskondensatoren aufweisen, welche weiter bevorzugt einer Zahl der Leistungsmodule entspricht. So kann eine Größe der Zwischenkreiskondensatoren, insbesondere eine Baugröße, oder zusätzlich eine Kapazität des Zwischenkreiskondensators, beschränkt sein. Vorteilhaft kann so eine Baugröße des Leistungsmoduls, und so auch des Elektromotors - im Vergleich zu einem Elektromotor mit nur einem Zwischenkreiskondensator für nur eine Leistungsendstufe -, reduziert sein.

In einer bevorzugten Ausführungsform weist der Elektromotor eine insbesondere zentrale Verarbeitungseinheit auf, welche mindestens mittelbar, bevorzugt über eine Schnittstelleneinheit, mit den Leistungsmodulen verbunden und ausgebildet ist, wenigstens ein Auslösesignal oder eine zeitliche Folge von Auslösesignalen für die Leistungsmodule zum Drehbewegen des Rotors zu erzeugen. Vorteilhaft kann so ein Notlauf-Ansteuersignal zum Drehbewegen des Rotors im Falle eines einen Defekt eines Leistungsmoduls repräsentierenden Fehlersignals zentral gesteuert erzeugt werden.

Die Schnittstelleneinheit ist bevorzugt eine Datenbus-Schnittstelleneinheit, insbesondere CAN-Bus- oder LIN-Bus-Schnittstelleneinheit, welche zur DatenKommunikation mit den Leistungsmodulen und der zentralen Verarbeitungseinheit ausgebildet ist. Beispielsweise kann die Schnittstelleneinheit von der zentralen Verarbeitungseinheit empfangene Auslösesignale an die Leistungsmodule zu senden.

Die zentrale Verarbeitungseinheit ist bevorzugt durch einen Mikroprozessor, weiter bevorzugt durch einen Multicore-Prozessor, gebildet.

Vorteilhaft kann eine Servolenkung, ein Elektrofahrzeug oder ein Elektrofahrrad den Elektromotor als Antriebsmotor aufweisen.

Der Elektromotor ist in einer anderen Ausführungsform Bestandteil eines Scheibenwischers oder eines Stellmotors, insbesondere eines Fensterhebers, eines Fahrzeugsitzes oder eines Schiebedaches. Vorteilhaft kann ein Fahrzeugsteuergerät als zentrale Verarbeitungseinheit den Elektromotor des Fensterhebers oder des Schiebedaches oder des Scheibenwischers über einen Datenbus, insbesondere CAN-Datenbus ansteuern.

Die Erfindung betrifft auch ein Leistungsmodul für den vorbeschriebenen Elektromotor. Das Leistungsmodul weist wenigstens die Halbleiterschalter-Halbbrücke, eine Treibereinheit zum Durchschalten oder Sperren der Halbbrücke, und eine Datenschnittstelle, insbesondere Datenbus-Schnittstelle zum Empfangen des Ansteuersignals, insbesondere des Auslösesignals oder zusätzlich des Drehmomentsignals auf.

Die Erfindung betrifft auch eine Steuereinheit für einen Elektromotor, wobei der Elektromotor einen Stator und einen Rotor umfasst.

Die Steuereinheit weist für jede Statorspule ein - bereits vorab beschriebenes - Leistungsmodul auf. Die Steuereinheit weist auch eine Schnittstelleneinheit, insbesondere Datenbus-Schnittstelleinheit auf, wobei jedes Leistungsmodul mit einem Ausgang der Steuereinheit zum Verbinden mit einer Statorspule des Stators verbunden ist. Die zentrale Verarbeitungseinheit ist über die Schnittstelleneinheit mit den Leistungsmodulen verbunden. Die Steuereinheit weist auch die bereits beschriebene zentrale Verarbeitungseinheit auf, welche mit den Leistungsmodulen - insbesondere bidirektional - verbunden ist. Die zentrale Verarbeitungseinheit ist ausgebildet, wenigstens ein Auslösesignal oder eine zeitliche Folge von Auslösesignalen für die Leistungsmodule zum Drehbewegen des Rotors zu erzeugen. Die zentrale Verarbeitungseinheit weist bevorzugt einen Eingang für ein Rotorpositionssignal auf, an den ein Rotorpositionssensor angeschlossen werden kann. Die Verarbeitungseinheit weist bevorzugt einen Eingang für das Temperatursignal des Temperatursensors, und bevorzugt einen Eingang für das Stromsignal des Stromsensors auf. Die Steuereinheit kann so vorteilhaft für Elektromotoren mit zueinander verschiedener Anzahl von Statorspulen konfiguriert werden.

Der Elektromotor weist bevorzugt wenigstens drei, oder ein Vielfaches von drei Statorspulen auf. Weiter bevorzugt beträgt die Anzahl der Statorspulen zwischen drei und vierundzwanzig Statorspulen.

Der Rotor des Elektromotors ist bevorzugt permanentmagnetisch, oder als Rotor mit wenigstens einer Rotorspule ausgebildet.

Die Erfindung betrifft auch ein Verfahren zum Ansteuern von Statorspulen eines elektronisch kommutierten Elektromotors umfassend wenigstens drei Statorspulen.

Der Elektromotor weist für jede Statorspule ein der Statorspule zugeordnetes und mit der Statorspule verbundenes Leistungsmodul auf. Das Leistungsmodul weist bevorzugt den Stromsensor und/oder den Temperatursensor auf.

Bei dem Verfahren wird ein Ansteuermuster zum Drehbewegen des Rotors von einer insbesondere zentralen Verarbeitungseinheit erzeugt wird, wobei das Ansteuermuster für jedes Leistungsmodul wenigstens ein Auslösesignal oder eine zeitliche Folge von Auslösesignalen aufweist, wobei die Auslösesignale über einen Datenbus an die Leistungsmodule gesendet werden, wobei das Leistungsmodul wenigstens in Abhängigkeit des Auslösesignals oder zusätzlich in Abhängigkeit eines ein Drehmoment repräsentierenden Drehmomentsignals ein Rotorsteuersignal, insbesondere PWM-Signal für einen Rotorwinkelbereich erzeugt und die Statorspule entsprechend dem Rotorsteuersignal bestromt.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt ein Ausführungsbeispiel für einen Elektromotor mit sechs Statorspulen und sechs Leistungsmodulen zum Bestromen der Statorspulen;
Figur 2 zeigt ein Ausführungsbeispiel für ein Leistungsmodul im Detail, bei dem ein Rotor-Steuersignal, insbesondere PWM-Signal von dem Leistungsmodul erzeugt werden kann;
Figur 3 zeigt einen Schnitt durch ein Leistungsmodul;
Figur 4 zeigt eine Aufsicht auf ein Leistungsmodul.

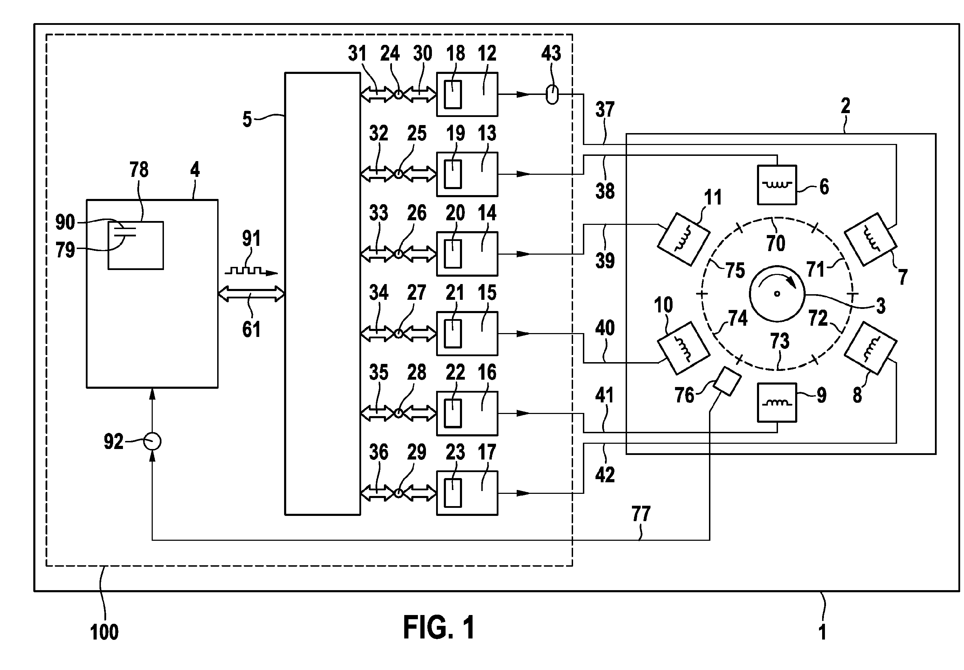

Figur 1 zeigt - schematisch - ein Ausführungsbeispiel für einen Elektromotor 1. Der Elektromotor 1 weist einen Stator 2 und einen Rotor 3, insbesondere einen permanentmagnetischen oder einen zum Bestromen ausgebildeten Rotor, auf.

Der Elektromotor 1 weist auch eine zentrale Verarbeitungseinheit 4 und eine Schnittstelleneinheit 5, in diesem Ausführungsbeispiel eine Datenbus-Schnittstelleneinheit, auf.

Der Stator 2 weist in diesem Ausführungsbeispiel sechs Statorspulen, nämlich eine Statorspule 6, eine Statorspule 7, eine Statorspule 8, eine Statorspule 9, eine Statorspule 10 und eine Statorspule 11 auf.

Der Elektromotor 1 kann in einer anderen Ausführungsform - anders als in Figur 1 dargestellt - auch eine andere Anzahl von Statorspulen, beispielsweise neun oder zwölf Statorspulen, aufweisen.

Der Elektromotor 1 weist für jede der Statorspulen 6, 7, 8, 9, 10 und 11 ein Leistungsmodul auf. Der Elektromotor 1 weist für die Statorspule 7 ein Leistungsmodul 12, für die Statorspule 6 ein Leistungsmodul 13 auf, für die Statorspule 11 ein Leistungsmodul 14, für die Statorspule 10 ein Leistungsmodul 15, für die Statorspule 9 ein Leistungsmodul 16 und für die Statorspule 8 ein Leistungsmodul 17 auf.

Der Stator 2 kann vorteilhaft die Leistungsmodule 12, 13, 14, 15, 16 17 umfassen, welche beispielsweise mit dem Stator verbunden sein können.

Das Leistungsmodul 12 ist ausgangsseitig über eine Verbindungsleistung 37 mit der Statorspule 7 verbunden, das Leistungsmodul 13 über eine Verbindungsleitung 38 mit der Statorspule 6, das Leistungsmodul 14 über eine Verbindungsleistung 39 mit der Statorspule 11, das Leistungsmodul 15 über eine Verbindungsleitung 40 mit der Statorspule 10, das Leistungsmodul 16 über eine Verbindungsleitung 41 mit der Statorspule 9 und das Leistungsmodul 17 über eine Verbindungsleitung 42 mit der Statorspule 8 verbunden.

Das Leistungsmodul 12 weist in diesem Ausführungsbeispiel eine Datenschnittstelle 18, insbesondere eine Datenbus-Schnittstelle, auf, welche ausgebildet ist, von der Schnittstelleneinheit 5 ein Steuersignal, insbesondere ein Trigger-Signal, zu empfangen und in Abhängigkeit des Steuersignals das Rotor-Steuersignal zum Drehbewegen des Rotors über einen der mit dem Leistungsmodul verbundenen Statorspule entsprechenden Rotorumlaufabschnitt zu erzeugen.

Der Statorspule 6 des Stators 2 ist ein Rotorumlaufabschnitt 70 zugeordnet, der Statorspule 7 ein Rotorumlaufabschnitt 71, der Statorspule 8 ein Rotorumlaufabschnitt 72, der Statorspule 9 ein Rotorumlaufabschnitt 73, der Statorspule 10 ein Rotorumlaufabschnitt 74 und der Statorspule 11 ist ein Rotorumlaufabschnitt 75 zugeordnet. Die Rotorumlaufabschnitte sind jeweils gestrichelt dargestellt.

Das Leistungsmodul 12 ist ausgebildet, für den dem Leistungsmodul 12 und der mit dem Leistungsmodul 12 verbundenen Statorspule 7 für den Rotorumlaufabschnitt 71 ein Bestromungsmuster zum Erzeugen eines magnetischen Drehfeldes im Bereich des Rotorumlaufabschnitts 71 zu erzeugen.

Das Leistungsmodul 13 weist zum Empfang des von der Schnittstelleneinheit 5 empfangenen Ansteuersignals, umfassend das Auslösesignal 91 und das Drehmomentsignal, eine Datenschnittstelle 19 auf, das Leistungsmodul 14 eine Datenschnittstelle 20, das Leistungsmodul 15 eine Datenschnittstelle 21, das Leistungsmodul 16 eine Datenschnittstelle 22 und das Leistungsmodul 17 eine Datenschnittstelle 23 auf.

Das Leistungsmodul 12, insbesondere die Datenschnittstelle 18, ist mittels einer bidirektionalen Verbindung 30 mit einem Schnittstellenanschluss 24 verbunden. Der Schnittstellenanschluss 24 ist beispielsweise durch einen Steckanschluss gebildet. Die Schnittstelleneinheit 5 ist über einen Datenbus 31 mit dem Schnittstellenanschluss 24 verbunden. Die Schnittstelleneinheit 5 ist ausgebildet, über den Datenbus 31 das eingangsseitig empfangene Ansteuersignal 91 zum Erzeugen des Rotorsteuersignals und des Bestromungsmusters für den Rotorumlaufabschnitt 71 zu empfangen und dieses über den Datenbus 31 an das Leistungsmodul 12, insbesondere die Datenschnittstelle 18, zu senden.

Das Leistungsmodul 13 ist über einen Schnittstellenanschluss 25 und über einen Datenbus 32 mit der Schnittstelleneinheit 5 verbunden, das Leistungsmodul 14 ist über einen Schnittstellenanschluss 26 und über einen Datenbus 33 mit der Schnittstelleneinheit 5 verbunden, das Leistungsmodul 15 ist über einen Schnittstellenanschluss 27 und über einen Datenbus 34 mit der Schnittstelleneinheit 5 verbunden, das Leistungsmodul 16 ist über einen Schnittstellenanschluss 28 und über einen Datenbus 35 mit der Schnittstelleneinheit 5 verbunden und das Leistungsmodul 17 ist über einen Schnittstellenanschluss 29 und über einen Datenbus 36 mit der Schnittstelleneinheit 5 verbunden. Die Leistungsmodule wie das Leistungsmodul 12 sind jeweils ausgebildet, mittels der Datenschnittstelle wie die Datenschnittstelle 18, über den Datenbus wie den Datenbus 31 mit der Schnittstelleneinheit 5 zu kommunizieren und dazu wenigstens ein Steuersignal an die Schnittstelleneinheit 5 zu senden und wenigstens ein Steuersignal von der Schnittstelleneinheit 5 zu empfangen.

Die Schnittstelleneinheit 5 ist mittels einer bidirektionalen Verbindung 61, insbesondre einer mehrkanaligen Verbindung, mit der zentralen Verarbeitungseinheit 4 verbunden. Die Verarbeitungseinheit 4 ist in diesem Ausführungsbeispiel als Multicore-Prozessor ausgebildet.

Die zentrale Verarbeitungseinheit 4 bildet in diesem Ausführungsbeispiel einen Master eines Steuersystems zum Ansteuern des Stators 2. Die Leistungsmodule wie das Leistungsmodul 12 bilden jeweils einen Slave des Steuersystems, umfassend die zentrale Verarbeitungseinheit 4.

Die zentrale Verarbeitungseinheit 4 ist ausgebildet, für jeden der Leistungsmodule wie das Leistungsmodul 12 ein Ansteuersignal, umfassend ein Auslösesignal oder zusätzlich ein Drehmomentsignal, zum Erzeugen des Bestromungsmusters zu erzeugen und dieses über die Schnittstelleneinheit 5, insbesondere CAN-Datenbus-Schnittstelleneinheit, an das Leistungsmodul wie das Leistungsmodul 12 zu senden.

Die Ansteuersignale bilden gemeinsam ein Ansteuermuster, das repräsentiert durch einen Ansteuermuster-Datensatz 90, in einem Speicher 78 der Verarbeitungseinheit 4 vorrätig gehalten sein kann.

Das Leistungsmodul wie das Leistungsmodul 12 ist ausgebildet, in Abhängigkeit des empfangenen Steuersignals, insbesondere Trigger-Signals, die Statorspule wie die Statorspule 7 zu bestromen und so auf dem Rotorumlaufabschnitt wie dem Rotorumlaufabschnitt 71 ein magnetisches Drehfeld zum Drehbewegen des Rotors 3 zu erzeugen.

Der Elektromotor 1, insbesondere der Stator 2, weist in diesem Ausführungsbeispiel auch einen Rotorpositionssensor 76 auf, welcher ausgebildet ist, eine Rotorposition des Rotors 3 zu erfassen und ein die Rotorposition des Rotors 3 repräsentierendes Rotorpositionssignal zu erzeugen und dieses über eine Verbindungsleitung 77 an die zentrale Verarbeitungseinheit 4 zu senden. Die zentrale Verarbeitungseinheit 4 weist einen Eingang 92 für das Rotorpositionssignal auf, welcher über die Verbindungsleitung 77 mit dem Rotorpositionssensor 76 verbunden ist.

Die zentrale Verarbeitungseinheit 4 ist ausgebildet, in Abhängigkeit des empfangenen Rotorpositionssignals das Steuersignal zum Erzeugen des Bestromungsmusters für jeden Rotorumlaufabschnitt wie den Rotorumlaufabschnitt 71 zu erzeugen und dieses an das entsprechende Leistungsmodul, beispielsweise das Leistungsmodul 12, zu senden.

Die zentrale Verarbeitungseinheit 4 kann beispielsweise im Falle eines Ausfalls eines Leistungsmoduls wie das Leistungsmodul 12 oder im Falle eines Defekts einer Statorspule wie die Statorspule 7 ein Notlaufprogramm starten und dazu ein Notlauf-Ansteuermuster, umfassend eine zeitliche Folge von Ansteuersignalen, erzeugen und die Ansteuersignale an die jeweiligen, noch intakten Leistungsmodule der Leistungsmodule 12, 13, 14, 15, 16 und 17 senden. Wenn beispielsweise das Leistungsmodul 13 in Folge eines Defekts eines Halbleiterschalters des Leistungsmoduls 13 ausfällt, so kann die zentrale Verarbeitungseinheit mittels des Notlauf-Ansteuermusters den Rotor 3 mittels der verbleibenden Leistungsmodule 12, 14, 15, 16 und 17 zu einem Rotorumlauf ansteuern. Die zentrale Verarbeitungseinheit 4 kann beispielsweise einen das Notlauf-Ansteuermuster repräsentierenden Notlauf-Datensatz 79 in dem Speicher 78 vorrätig halten.

Die Leistungsmodule 12, 13, 14, 15, 16, und 17, die Schnittstelleneinheit 5 und die zentrale Verarbeitungseinheit 4 können Bestandteil einer - gestrichelt dargestellten - Steuereinheit 100 sein, welche zum Verbinden mit einem Stator wie dem Stator 2 ausgebildet ist. Dazu weist die Steuereinheit 100 für jede der Leistungsendstufen 12, 13, 14, 15, 16, und 17 einen Ausgang wie dem Ausgang 43 auf.

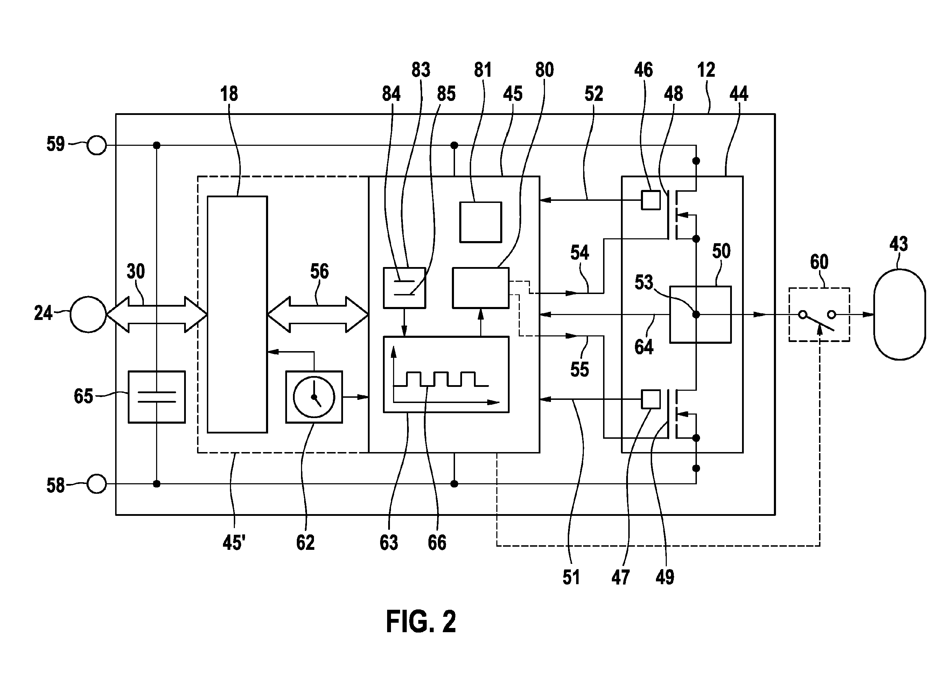

Figur 2 zeigt ein Ausführungsbeispiel für das in Figur 1 bereits dargestellte Leistungsmodul 12. Die Leistungsmodule 13, 14, 15, 16 und 17 können jeweils wie das Leistungsmodul 12 ausgebildet sein.

Das Leistungsmodul 12 ist in diesem Ausführungsbeispiel ausgangsseitig über einen Anschluss 43, welcher auch in Figur 1 dargestellt ist, mit der Statorspule 7 des Stators 2 verbunden.

Das Leistungsmodul 12 weist eine Halbleiterschalter-Halbbrücke 44 auf, welche einen High-Side-Halbleiterschalter 48 und einen Low-Side-Halbleiterschalter 49 aufweist. Die Halbleiterschalter 48 und 49 sind in diesem Ausführungsbeispiel als Feldeffekttransistor, insbesondere MOS-FET (MOS = Metal-Oxide-Semiconductor) oder MIS-FET (MIS = Metal-Insulated-Semiconductor) ausgebildet.

Ein Source-Anschluss des Halbleiterschalters 48 ist über einen Verbindungsknoten 53 mit einem Drain-Anschluss des Halbleiterschalters 49 verbunden. Der Verbindungsknoten 53 bildet so einen Ausgang der Halbleiterschalter-Halbbrücke 44.

Das Leistungsmodul 12 weist auch eine Treibereinheit 45 auf, welche die vorab beschriebene Verarbeitungseinheit des Leistungsmoduls bildet. Die Treibereinheit 45 weist in diesem Ausführungsbeispiel einen Pulsweitenmodulator 63 auf, welcher ausgebildet ist, ein PWM-Signal 66 zum Erzeugen eines Bestromungsmusters mittels der Halbleiterschalter-Halbbrücke 44 zu erzeugen. Die Treibereinheit 45 ist ausgangsseitig über eine Steuerleitung 54 mit einem Steueranschluss des Halbleiterschalters 48 verbunden und über eine Steuerleitung 55 mit einem Steueranschluss des Halbleiterschalters 49 verbunden. Die Treibereinheit 45 weist in diesem Ausführungsbeispiel einen Gate-Treiber 80 auf, welcher eingangsseitig mit dem Pulsweitenmodulator 63 verbunden und ausgebildet ist, in Abhängigkeit des eingangsseitig empfangenen PWM-Signals 66 die Steueranschlüsse der Halbleiterschalter 48 und 49 zum Öffnen oder Schließen der Halbleiterschalter anzusteuern. Der Gate-Treiber 80 kann beispielsweise einen Levelshifter aufweisen, sodass die Halbleiterschalter 48 und 49 sicher durchgesteuert oder gesperrt werden können.

Das Leistungsmodul 12 weist auch einen elektrischen Anschluss 59 und einen Masseanschluss 58 auf.

Die Halbleiterschalter-Halbbrücke 44 ist zum Empfangen einer Versorgungsspannung mit dem Anschluss 59 und mit dem Anschluss 59 verbunden. Dazu ist ein Drain-Anschluss des Halbleiterschalters 48 mit dem Anschluss 59 und ein Source-Anschluss des Halbleiterschalters 49 mit dem Masseanschluss 58 verbunden.

Die Halbleiterschalter-Halbbrücke 44 weist in diesem Ausführungsbeispiel auch einen Temperatursensor 46 auf, welcher ausgebildet und angeordnet ist, eine Temperatur des Halbleiterschalters 48 zu erfassen und ein die Temperatur des Halbleiterschalters 48 repräsentierendes Temperatursignal zu erzeigen. Der Temperatursensor 46 ist über eine Verbindungsleitung 52 mit der Treibereinheit 45 verbunden. Die Halbleiterschalter-Halbbrücke 44 weist auch einen Temperatursensor 47 zum Erfassen einer Temperatur des Low-Side-Halbleiterschalters 49 auf, welche über eine Verbindungsleitung 51 mit der Treibereinheit 45 verbunden ist. Die Treibereinheit 45 ist so ausgebildet, in Abhängigkeit der eingangsseitig empfangenen Temperatursignale der Temperatursensoren 46 und 47 eine Übertemperatur des High-Side-Halbleiterschalters 48, beziehungsweise des Low-Side-Halbleiterschalters 49 zu erfassen und in Abhängigkeit des empfangenen Temperatursignals ein Fehlersignal zu erzeugen. Die Treibereinheit 45 weist dazu eine Verarbeitungseinheit 81 auf, welche ausgebildet ist, in Abhängigkeit des empfangenen Temperatursignals das Fehlersignal zu erzeugen. Die Verarbeitungseinheit 81 ist beispielsweise durch einen integrierten Logik-Schaltkreis, insbesondere FPGA (FPGA = Field-Programmable-Gate-Array), ein ASIC (ASIC = Application-Specific-Integrated-Circuit), ein PLC (PLC = Programmable-Logic-Device) oder einen Mikrocontroller gebildet.

Die Halbleiterschalter-Halbbrücke 44 weist in diesem Ausführungsbeispiel auch einen Stromsensor 50 auf. Der Stromsensor 50 ist in diesem Ausführungsbeispiel als Hall-Sensor ausgebildet und ist ausgebildet und angeordnet, einen über den Verbindungsknoten 53, und so über den Ausgang der Halbleiterschalter-Halbbrücke 44 fließenden, Strom zu erfassen und ein den erfassten Strom repräsentierendes Stromsignal zu erzeugen. Der Stromsensor 50 ist ausgangsseitig über eine Verbindungsleitung 64 mit der Treibereinheit 45 verbunden. Die Treibereinheit 45, insbesondere die Verarbeitungseinheit 81, ist ausgebildet, in Abhängigkeit des eingangsseitig empfangenen Stromsignals ein Statussignal, insbesondere ein In-Ordnung-Signal oder ein Fehlersignal, zu erzeugen und das Fehlersignal über eine bidirektionale Verbindung 56 an die Datenschnittstelle 18 zu senden. Die Datenschnittstelle 18 ist über die bidirektionale Verbindung 56 mit der Treibereinheit 45 verbunden und ausgebildet, das Statussignal, insbesondere das In-Ordnung-Signal oder das Fehlersignal, über die in Figur 1 bereits dargestellte bidirektionale Verbindung 30 an den Datenanschluss 24 zu senden und dort bereitzustellen. Die in Figur 1 dargestellte Schnittstelleneinheit 5 kann das Statussignal von dem Datenanschluss 24 über den Datenbus 31 empfangen und über die bidirektionale Verbindung 61 an die zentrale Verarbeitungseinheit 4 senden.

Die Treibereinheit 45 ist eingangsseitig mit einem Zeitgeber 62, beispielsweise einem Schwingquarz, verbunden und ausgebildet, ein von dem Zeitgeber 62 erzeugtes Zeitsignal, insbesondere Taktsignal, zu empfangen. Der Zeitgeber 62 ist auch ausgangsseitig mit der Datenschnittstelle 18 verbunden, sodass die zentrale Verarbeitungseinheit 4 das von einem Zeitgeber 62 erzeugte Zeitsignal auch über den Datenbus 31 und die Schnittstelleneinheit 5 empfangen kann. So kann die zentrale Verarbeitungseinheit 4 zum Erzeugen des magnetischen Drehfeldes die Steuersignale zum Ansteuern der Leistungsmodule 12, 13, 14, 15, 16 und 17 zeitsynchronisiert erzeugen, sodass ein Rotorumlauf des Rotors 3 frei von Drehmomentwelligkeit oder mit nur geringer Drehmomentwelligkeit erzeugt werden kann. Die zentrale Verarbeitungseinheit 4 kann zum Erzeugen eines synchronisierten Rotorumlaufes ein Zeitsignal des Pulsweitenmodulators des Leistungsmoduls, beispielsweise das Zeitsignal des Zeitgebers 62 des Leistungsmoduls 12, als Referenz-Zeitsignal empfangen und in Abhängigkeit des Referenz-Zeitsignals die Steuersignale zum Ansteuern der übrigen Leistungsmodule erzeugen.

Das Leistungsmodul 12 weist in diesem Ausführungsbeispiel auch einen Zwischenkreiskondensator 65 auf. Der Zwischenkreiskondensator 65 ist mit einem Kondensatoranschluss mit dem Anschluss 59 verbunden und mit einem weiteren Kondensatoranschluss mit dem Masseanschluss 58 verbunden.

Das Leistungsmodul 12 kann - unabhängig oder zusätzlich zu den vorab beschriebenen Komponenten des Leistungsmoduls 12 - einen Phasentrennschalter 60 aufweisen, welcher zwischen dem Ausgangsanschluss 43 und dem Verbindungsknoten 53 angeordnet ist. Der Phasentrennschalter 60 ist in diesem Ausführungsbeispiel steuerbar ausgebildet und kann über eine gestrichelt dargestellte Verbindungsleitung von der Treibereinheit 45 ein Trennsignal zum Abtrennen des Ausgangsanschlusses 43 von der Halbleiterschalter-Halbbrücke 44 empfangen und den Ausgangsanschluss 43 in Abhängigkeit des Trennsignals von der Halbleiterschalter-Halbbrücke 44 verbinden oder trennen. Das Trennsignal kann beispielsweise von der Treibereinheit 45 in Abhängigkeit des zuvor beschriebenen Fehlersignals erzeugt werden.

Die Treibereinheit 45 weist in diesem Ausführungsbeispiel auch einen Speicher 83 auf, in dem ein PWM-Datensatz 85 vorrätig gehalten ist, welcher das PWM-Signal 66 repräsentiert und ein Notlauf-Datensatz 84 vorrätig gehalten ist, welcher ein Notlauf-PWM-Signal repräsentiert. Der Pulsweitenmodulator 63 kann in Abhängigkeit des von der zentralen Verarbeitungseinheit 4 über den Datenbus 31 und die Datenschnittstelle 18 empfangenen Fehlersignals den Notlauf-Datensatz 84 aus dem Speicher 83 auslesen und das entsprechende Notlauf-PWM-Signal zum Bestromen der Statorspule 7 und zum Erzeugen eines magnetischen Notlauf-Drehfeldes auf dem Rotorumfangsabschnitt 71 erzeugen.

Das Fehlersignal kann in diesem Fall von einem anderen Leistungsmodul, beispielsweise einem defekten Leistungsmodul 13, erzeugt worden sein. Die zentrale Verarbeitungseinheit 4 kann dann mittels der noch verbleibenden Leistungsmodule und den Notlauf-PWM-Mustern einen Rotorumlauf - beispielsweise mit reduziertem Drehmoment - erzeugen.

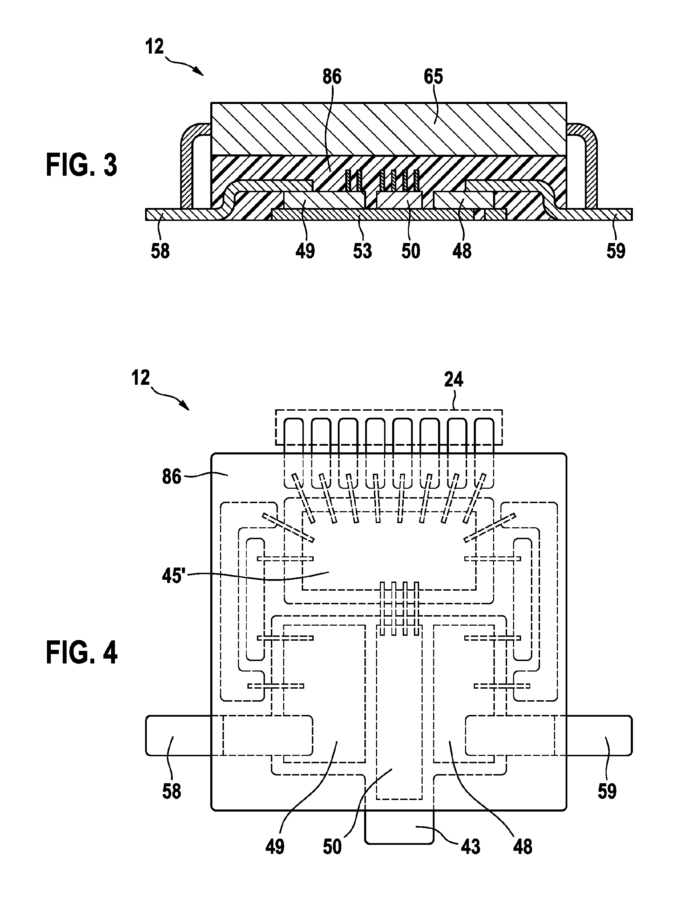

Figur 3 zeigt eine beispielhafte Schnittdarstellung einer beispielhaften Ausführungsform für das in den Figuren 1 und 2 dargestellte Leistungsmodul 12. Der Verbindungsknoten 53 ist in Figur 3 durch ein Verbindungsblech, insbesondere Lead-Frame, gebildet. Der High-Side-Halbleiterschalter 48 ist mit seinem Drain-Anschluss über eine als Lead-Frame ausgebildete Verbindungsleitung mit dem Anschluss 59 verbunden. Der Low-Side-Halbleiterschalter 49 ist mit seinem Source-Anschluss mittels einer als Lead-Frame ausgebildeten elektrischen Verbindungsleitung mit dem Masseanschluss 58 verbunden. Der Zwischenkreiskondensator 65 ist mit einem Kondensatoranschluss mit dem Masseanschluss 58 und mit einem weiteren Kondensatoranschluss mit dem Anschluss 59 verbunden. Der Anschluss 59 bildet in diesem Ausführungsbeispiel einen Anschluss für eine Versorgungsspannung, insbesondere eine Batteriespannung.

Das Leistungsmodul 12 weist in diesem Ausführungsbeispiel auch ein Modul-Gehäuse 86 auf, wobei das Modul-Gehäuse 86 den High-Side-Halbleiterschalter 48 und den Low-Side-Halbleiterschalter 49, den Stromsensor 50, die Treibereinheit 45 und die Datenschnittstelle 18 umschließt. Das Modul-Gehäuse 86 ist beispielsweise ein Mold-Gehäuse, bei dem die Halbleiterschalter 48 und 49 in eine Mold-Masse eingebettet sind.

Figur 4 zeigt ein Ausführungsbeispiel für das in Figur 3 bereits dargestellte Leistungsmodul 12 in einer Aufsicht. Die Treibereinheit 45 ist ausgangsseitig mit dem Datenanschluss 24 verbunden, wobei elektrische Anschlüsse des Datenanschlusses 24 aus dem Mold-Gehäuse 86 herausragen.

Der Ausgangsanschluss 43, der Anschluss 59 zum Empfangen einer Versorgungsspannung und der Masseanschluss 58 ragen jeweils aus dem Mold-Gehäuse 86 heraus. Die Treibereinheit 45' umfasst in diesem in Figur 4 dargestellten Ausführungsbeispiel auch die Datenschnittstelle 18 und den Zeitgeber 62. Die Ausführungsvariante der Treibereinheit gemäß Figur 4 ist in Figur 2 durch eine gestrichelt dargestellte Treibereinheit 45' dargestellt.

## Patentansprüche

1. Elektronisch kommutierter Elektromotor (1),
mit einem Stator (2) und einem Rotor (3), wobei der Stator (2) wenigstens drei Statorspulen (6, 7, 8, 9, 10, 11) aufweist, und wenigstens einem mit dem Stator (2) ausgangsseitig verbundenen Leistungsmodul (12, 13, 14, 15, 16, 17), welche ausgebildet ist den Stator (2) zum Erzeugen eines magnetischen Drehfeldes zu bestromen,
**dadurch gekennzeichnet, dass**
der Elektromotor (1) für jede Statorspule (6, 7, 8, 9, 10, 11) ein der Statorspule (6, 7, 8, 9, 10, 11) zugeordnetes Leistungsmodul (12, 13, 14, 15, 16, 17) aufweist, welches ausgangsseitig mit der Statorspule (6, 7, 8, 9, 10, 11) verbunden ist, wobei das Leistungsmodul (12, 13, 14, 15, 16, 17) eine Halbleiterschalter-Halbbrücke (44) und eine Verarbeitungseinheit (45) aufweist, welche ausgebildet ist, die Halbleiterschalter-Halbbrücke (44) zum Erzeugen eines magnetischen Drehfeldes für einen der Statorspule (6, 7, 8, 9, 10, 11) entsprechenden Rotorumlaufabschnitt anzusteuern, und dazu in Abhängigkeit eines eingangsseitig empfangenen Auslösesignals (91) ein Rotor-Steuersignal (66) zu erzeugen, das ein rotorwinkelabhängiges Bestromungsmuster zum Bestromen der Statorspule (6, 7, 8, 9, 10, 11) repräsentiert und dieses an die Halbleiterschalter-Halbbrücke (44) zu senden.

2. Elektromotor nach Anspruch 1,
**dadurch gekennzeichnet, dass**
das Leistungsmodul (12, 13, 14, 15, 16, 17) eine Datenschnittstelle (18, 19, 20, 21, 22, 23) aufweist, welche ausgebildet ist, ein Auslösesignal (91) zum Erzeugen des Rotor-Steuersignals (66) zu empfangen und die Verarbeitungseinheit (81) ausgebildet ist, das Rotor-Steuersignal (66) in Abhängigkeit des Auslösesignals (91) zu erzeugen und den Rotor (3) so zum Drehbewegen anzusteuern.

3. Elektromotor (1) nach Anspruch 2,
**dadurch gekennzeichnet, dass**
die Datenschnittstelle (12, 13, 14, 15, 16, 17) eine Datenbus-Schnittstelle ist.

4. Elektromotor (1) nach einem der vorhergehenden Ansprüche,
**dadurch gekennzeichnet, dass**
das Leistungsmodul (12, 13, 14, 15, 16, 17) einen mit der Verarbeitungseinheit (45) verbundenen Temperatursensor (46, 47) aufweist, welcher ausgebildet ist, eine Temperatur der Halbleiterschalter-Halbbrücke (44), insbesondere eines Halbleiterschalters (48, 49) der Halbleiterschalter-Halbbrücke (44) zu erfassen und ein die Temperatur repräsentierendes Temperatursignal zu erzeugen, wobei die Verarbeitungseinheit (45) ausgebildet ist, das Temperatursignal zu empfangen und in Abhängigkeit des Temperatursignals ein Statussignal, insbesondere Fehlersignal zu erzeugen und ausgangsseitig an die Schnittstelle (18) auszugeben.

5. Elektromotor (1) nach einem der vorhergehenden Ansprüche,
**dadurch gekennzeichnet, dass**
das Leistungsmodul (12, 13, 14, 15, 16, 17) einen mit der Verarbeitungseinheit verbundenen Stromsensor (50) aufweist, welcher ausgebildet ist, einen Ausgangsstrom der Halbleiterschalter-Halbbrücke (44) und/oder einen durch die Halbleiterschalter-Halbbrücke (44) fließenden Strom zu erfassen und ein den Strom repräsentierendes Stromsignal zu erzeugen, wobei die Verarbeitungseinheit (45) ausgebildet ist, das Rotor-Steuersignal (66) in Abhängigkeit des Strom-signals zu erzeugen.

6. Elektromotor (1) nach Anspruch 5,
**dadurch gekennzeichnet, dass**
der Stromsensor (50) ein Magnetfeldsensor, insbesondere Hall-Sensor, GMR-Sensor oder AMR-Sensor ist, welcher angeordnet und ausgebildet ist, den Ausgangsstrom und/oder den durch die Halbleiterschalter-Halbbrücke (44) fließenden Strom zu erfassen.

7. Elektromotor (1) nach einem der vorhergehenden Ansprüche,
**dadurch gekennzeichnet, dass**
die Verarbeitungseinheit (45) ausgebildet ist, einen Fehler der Halbbrücke und/oder der Statorspule, insbesondere einen Kurzschluss der Halbleiterschalter-Halbbrücke (44) und/oder eine Überspannung einer Versorgungsspannung der Halbleiterschalter-Halbbrücke (44) zu erfassen und ein den Fehler repräsentierendes Fehlersignal zu erzeugen und an die Schnittstelle (5) auszugeben.

8. Elektromotor nach einem der vorhergehenden Ansprüche,
**dadurch gekennzeichnet, dass**
jedes der Leistungsmodule einen Zwischenkreiskondensator aufweist, welcher mit Schaltanschlüssen der Halbbrücke des Ansteuermoduls verbunden ist.

9. Elektromotor (1) nach einem der vorhergehenden Ansprüche,
**dadurch gekennzeichnet, dass**
der Elektromotor (1) eine mit den Leistungsmodulen (12, 13, 14, 15, 16, 17) mindestens mittelbar verbundene insbesondere zentrale Verarbeitungseinheit (4) aufweist, welche ausgebildet ist, wenigstens ein Auslösesignal (91) oder eine zeitliche Folge von Auslösesignalen (91) für die Leistungsmodule (12, 13, 14, 15, 16, 17) zum Drehbewegen des Rotors (3) zu erzeugen.

10. Steuereinheit (100) für einen Elektromotor (1), wobei der Elektromotor (1) einen Stator (2) und einen Rotor (3) umfasst,
**dadurch gekennzeichnet, dass**
die Steuereinheit (100) für jede Statorspule (6, 7, 8, 9, 10, 11) des Stators (2) ein Leistungsmodul (12, 13, 14, 15, 16, 17) aufweist, und die Steuereinheit (100) eine Schnittstelleneinheit (5) aufweist, wobei jedes Leistungsmodul mit einem Ausgang (43) der Steuereinheit (100) zum Verbinden mit einer Statorspule (6, 7, 8, 9, 10, 11) des Stators (2) verbunden ist, und die Steuereinheit (100) eine zentrale Verarbeitungseinheit (4) aufweist, welche über die Schnittstelleinheit (5) mit den Leistungsmodulen verbunden und ausgebildet ist, wenigstens ein Auslösesignal (91) oder eine zeitliche Folge von Auslösesignalen (91) für die Leistungsmodule (12, 13, 14, 15, 16, 17) zum Drehbewegen des Rotors (3) zu erzeugen, wobei das Leistungsmodul (12, 13, 14, 15, 16, 17) eine Halbleiterschalter-Halbbrücke (44) und eine Verarbeitungseinheit (45) aufweist, welche ausgebildet ist, die Halbleiterschalter-Halbbrücke (44) zum Erzeugen eines magnetischen Drehfeldes für einen der Statorspule (6, 7, 8, 9, 10, 11) entsprechenden Rotorumlaufabschnitt anzusteuern, und dazu in Abhängigkeit eines eingangsseitig empfangenen Auslösesignals (91) ein Rotor-Steuersignal (66) zu erzeugen, das ein Bestromungsmuster zum Bestromen der Statorspule (6, 7, 8, 9, 10, 11) repräsentiert und dieses an die Halbleiterschalter-Halbbrücke (44) zu senden.

11. Verfahren zum Drehbewegen eines Rotors (3) eines Elektromotors (1) umfassend wenigstens drei Statorspulen (6, 7, 8, 9, 10, 11) und für jede Statorspule (6, 7, 8, 9, 10, 11)ein der Statorspule zugeordnetes und mit der Statorspule (6, 7, 8, 9, 10, 11) verbundenes Leistungsmodul (12, 13, 14, 15, 16, 17),
**dadurch gekennzeichnet, dass**
ein Ansteuermuster zum Drehbewegen des Rotors von einer insbesondere zentralen Verarbeitungseinheit (4) erzeugt wird, wobei das Ansteuermuster für jedes Leistungsmodul (12, 13, 14, 15, 16, 17) wenigstens ein Auslösesignal (91) oder eine zeitliche Folge von Auslösesignalen (91) aufweist, wobei die Auslösesignale (91) über einen Datenbus (5) an die Leistungsmodule (12, 13, 14, 15, 16, 17) gesendet werden, wobei das Leistungsmodul (12, 13, 14, 15, 16, 17) wenigstens in Abhängigkeit des Auslösesignals (91) oder zusätzlich in Abhängigkeit eines ein Drehmoment repräsentierenden Drehmomentsignals ein Rotorsteuersignal (66), insbesondere PWM-Signal für einen Rotorwinkelbereich (70, 71, 72, 73, 74, 75) erzeugt und die Statorspule (6, 7, 8, 9, 10, 11) entsprechend dem Rotorsteuersignal (66) bestromt.
